# EUROPEAN PATENT APPLICATION

(11) **EP 1 662 514 A1**
(43) Date of publication of application: **31.05.2006**
(21) Application number: 04746800.4
(22) Date of filing: 01.07.2004
(51) Int. Cl.: H01B 13/00

(54) **PROCESS FOR PRODUCING OXIDE SUPERCONDUCTIVE WIRE**

(30) Priority: 16.07.2003 JP 2003197498
(71) Applicant: Sumitomo Electric Industries, Ltd., Osaka-shi, Osaka 541-0041 (JP)
(72) Inventor: HAHAKURA, Shuji, SUMITOMO ELECTRIC INDUSTRIES,LTD., Osaka-shi, Osaka 5548511 (JP); OHMATSU, Kazuya, SUMITOMO ELECTRIC INDUSTRIES,LTD., Osaka-shi, Osaka 5548511 (JP); KONISHI, Masaya, SUMITOMO ELECTRIC INDUSTRIES, LTD, Osaka-shi, Osaka 5548511 (JP); FUJINO, Koso, SUMITOMO ELECTRIC INDUSTRIES, LTD., Osaka-shi, Osaka 5548511 (JP)
(74) Representative: Kreutzer, Ulrich
(86) International application number: PCT/JP2004/009331
(87) International publication number: WO 2005/008688

(57) **Abstract**

A method of manufacturing an oxide superconductive wire includes the step of positioning a metal tape (6) in a position at a distance (L) of at most 100 mm from a target (7) for generating an oxide, and the step of forming an oxide superconductive layer on the metal tape (6) using a vapor deposition method while transferring the metal tape (6) at a transfer speed of at least 5 m/h with keeping the distance (L) between the metal tape (6) and the target (7) of at most 100 mm.

## Description

### Technical Field

The present invention relates to a method of manufacturing an oxide superconductive wire. More specifically, the present invention relates to a method of manufacturing an oxide superconductive wire including an oxide superconductive layer deposited on a metal tape.

### Background Art

An oxide superconductive wire has a characteristic that a critical current density (Jc) of at least 1 MA/cm² can be obtained at a relatively high temperature (77 K) as compared to other superconductive materials, and therefore expectations for mass production thereof are rising.

In a conventional technique, a Jc larger than 1 MA/cm² is already attained with a superconductive wire having a short length. With the oxide superconductive wire having a long length, however, a technique for attaining the Jc of at least 1 MA/cm² should be developed from now on.

A reason why the Jc cannot be increased in the oxide superconductive wire having a long length is described here. It is because, when the oxide superconductive wire is made long, an oxide used becomes long, which makes it difficult to maintain crystal orientation in the same direction.

One of measures against this problem is a method in which an oxide superconductive thin film is deposited by laser ablation in a film formation chamber, which oxide superconductive thin film is then continuously subjected to heat treatment in an oxygen introduction chamber. With this, an inherent characteristic of the oxide superconductive thin film is brought out (Japanese Patent Laying-Open No. 2001-357739: Patent Document 1).

In addition, there is a technique in which an Ag layer is provided beforehand on a metal tape to be a base material, and a plurality of oxide superconductive layers are deposited on the Ag layer. There is also a technique for supplying a composition of a reaction solution in a chemical vapor deposition (CVD) method such that, a Cu component in an oxide superconductive layer deposited on a side of the Ag layer becomes more excessive than a Cu component in an oxide superconductive layer deposited thereon (see Japanese Patent Laying-Open No. 2003-092036: Patent Document 2).

Furthermore, there is a technique for forming a uniform film with a physical vapor deposition (PVD) method, in which a plurality of tapes are combined and arranged between a metal tape as an object and a target to selectively deposit particles generated from the target on the metal tape as the object (see Japanese Patent Laying-Open No. 2003-171764: Patent Document 3).
Patent Document 1: Japanese Patent Laying-Open No. 2001-357739
Patent Document 2: Japanese Patent Laying-Open No. 2003-092036
Patent Document 3: Japanese Patent Laying-Open No. 2003-171764

### Disclosure of the Invention

### Problems to be Solved by the Invention

If a large critical current density (Jc) in an oxide superconductive wire having a short length can be maintained over a long length, mass production of the oxide superconductive wire becomes possible. Though some success is described in each disclosure of various manufacturing methods as described above, further increase in performance is required. A measure with other means has been examined.

### Means for Solving the Problems

The inventor of the present invention studied manufacturing conditions closely and, as a result, found out a superior manufacturing method. That is, when an oxide superconductive layer is formed on a metal tape using a vapor deposition method in the present invention, a transfer speed of the tape is set to at least 5 m/h, and a distance between the tape and a target for generating an oxide is set to at most 100 mm. Though film formation is possible with a transfer speed of the tape lower than 5 m/h, the transfer speed is preferably set to at least 5 m/h in order to increase a Jc of a resulting oxide superconductive wire. In addition, though film formation is possible with a distance between the metal tape and the target larger than 100 mm, as the distance between the metal tape and the target increases, a thin film of the oxide becomes thinner and the Jc cannot be increased.

A method of manufacturing an oxide superconductive wire according to the present invention includes the step of positioning a metal tape in a position at a distance of at most 100 mm from a target for generating an oxide, and the step of forming an oxide superconductive layer on the metal tape using a vapor deposition method while transferring the metal tape at a transfer speed of at least 5 m/h with keeping the distance between the metal tape and the target of at most 100 mm.

The vapor deposition method is preferably a laser deposition (PDL) method. In addition, the method of manufacturing becomes more preferable when the oxide superconductive layer is a rare-earth-barium-copper-based superconductive oxide (RE 123; RE = rare-earth element, Y).

### Effects of the Invention

According to the present invention, a method of manufacturing an oxide superconductive wire which can attain a superior critical current density can be provided.

### Brief Description of the Drawings

Fig. I is a schematic diagram of a device for performing a method of manufacturing an oxide superconductive wire according to the present invention.

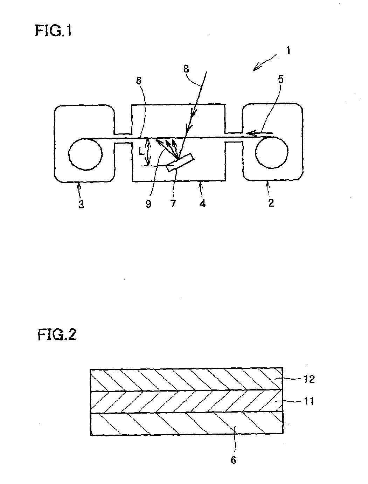

Fig. 2 is a cross-sectional view of an oxide superconductive wire which is manufactured according to the present invention.

### Description of the Reference Signs

1: film formation device, 2: substrate supply portion, 3: substrate take-up portion, 4: film formation chamber, 5, 9: arrow, 6: metal tape, 7: target, 8: laser light, 11:
intermediate layer, 12; oxide superconductive layer,

### Best Modes for Carrying Out the Invention

An embodiment of the present invention will now be described referring to the drawings. Fig. 1 is a schematic diagram of a device for performing a method of manufacturing an oxide superconductive wire according to the present invention. Referring to Fig. 1, a film formation device 1 includes a supply portion 2 and a substrate take-up portion 3. In film formation device 1, a film formation chamber 4 is arranged between supply portion 2 and substrate take-up portion 3. Supply portion 2, take-up portion 3 and film formation chamber 4 are preferably formed to have respective closed spaces or substantially closed spaces.

A metal tape 6, which is a flexible and long substrate, is pulled out from supply portion 2 as indicated with an arrow 5, passes through film formation chamber 4, and is then taken up in take-up portion 3.

More specifically, an oxide superconductive thin layer is formed in film formation chamber 4 with laser ablation for metal tape 6 pulled out from supply portion 2. In film formation chamber 4, a target 7 is arranged to be opposed to metal tape 6 as the substrate, and target 7 is irradiated with laser light 8 from the outside of film formation chamber 4. Target 7 includes a component of an oxide superconductive substance. A particle made of a substance forming target 7 is released from target 7 irradiated with laser light 8 as indicated with an arrow 9, and the particle is deposited on metal tape 6 to form an oxide superconductive layer. Metal tape 6 having the oxide superconductive layer formed thereon is taken up in take-up portion 3. Metal tape 6 having an oxide superconductive thin film formed thereon which is taken up in take-up portion 3 is then removed from take-up portion 3 and subjected to heat treatment in an oxygen atmosphere in a heat treatment furnace. With this, an oxide superconductive wire including metal tape 6 having a long length with the oxide superconductive layer formed thereon is obtained.

Fig. 2 is a cross-sectional view of an oxide superconductive wire which is manufactured according to the present invention. Referring to Fig. 2, a thin film-like intermediate layer 11 is formed on metal tape 6. An oxide superconductive layer 12 is formed on intermediate layer 11.

When oxide superconductive layer 12 is formed, a distance L between target 7 and metal tape 6 is kept to at most 100 mm. In addition, a transfer speed of metal tape 6 in a direction indicated with arrow 5 is set to at least 5 m/h.

In the method of manufacturing an oxide superconductive wire according to the present invention, since a conventional film formation speed is increased, crystal orientation of the oxide superconductive layer formed is aligned in the same direction, and thereby a large critical current value (Jc) can be maintained over a long length. To perform film formation at a high speed as such, a condition of a substrate surface (wire surface) on which the oxide superconductive substance is deposited naturally becomes important.

In the present invention, the metal tape which is easily made to have a long length is used as a base material of the oxide superconductive wire. Preferable materials of metal tape 6 include an Ni-Fe alloy, stainless, a composite material of an alloy including Ni, and the like.

On metal tape 6, intermediate layer 11 is preferably provided rather than directly depositing oxide superconductive layer 12. Yttria-stabilized zirconia (YSZ), CeO₂ or the like can be selected as the intermediate layer for helping orientation of the crystal of oxide superconductive layer 12. Though various means for depositing intermediate layer 11 on metal tape 6 are possible, performance for maintaining the orientation of oxide superconductive layer 12 over a long length largely depends on orientation of intermediate layer 11. An inclined substrate deposition (ISD) method or a reverse ISD method, which is an improved method of the ISD, is preferably used.

In the reverse ISD method, the intermediate layer is once deposited to have a thickness of half of a designed value, and a remaining half portion is produced in a condition of reverse inclination. Since a crystal deviation angle can be corrected by adopting the method as such, the oxide superconductive layer with higher orientation can be deposited and, as a result, the Jc can be increased.

In addition, an orientation substrate is preferably used as the metal tape. An intermediate layer is preferably stacked on the orientation substrate for preventing diffusion of an element and increasing lattice alignment with the oxide superconductive layer.

The method of manufacturing according to the present invention is a method of depositing a superconductive layer on the metal tape having the intermediate layer deposited thereon as described above. A rare-earth-barium-copper-based superconductive oxide (RE123; RE = rare-earth element, Y) which exhibits a superconductive property at a high temperature is especially preferable as a material of the oxide superconductive layer used for deposition.

A vapor deposition method is used as means for deposition. When the target including a superconductive substance to be deposited on the intermediate layer is remote from the intermediate layer, a sufficient thickness of a deposit cannot be ensured because a transfer speed of the metal tape is high. Therefore, a distance between the target and the intermediate layer subjected to deposition must be set to at most 100 mm. Then, the transfer speed of the metal tape is set to at least 5 m/h. The critical current density (Jc) cannot be increased with the transfer speed lower than 5 m/h. This is because a thermal history applied to the intermediate layer and the metal tape by an atmosphere heated during deposition of the oxide superconductive layer affects a value of the Jc. When the transfer speed is low, a degree of the thermal history is large, and when the transfer speed goes beyond 5 m/h, the thermal history does not have a large effect on formation of the oxide superconductive layer.

The method of manufacturing an oxide superconductive wire according to the present invention includes the step of positioning metal tape 6 in a position at distance L of at most 100 mm from target 7 for generating an oxide, and the step of forming oxide superconductive layer 12 on metal tape 6 using the vapor deposition method while transferring metal tape 6 at the transfer speed of at least 5 m/h with keeping distance L between metal tape 6 and target 7 of at most 100 mm.

Though examples of the present invention are described below, the present invention is not limited to these examples.

### (Example 1)

An orientation substrate of an Ni group alloy (0.1 mm thickness x 10 mm width x 50 m length) having yttria-stabilized zirconia (YSZ) of a thickness of 1 µm deposited thereon as an intermediate layer was prepared. On this substrate, an oxide superconductive layer of HoBa₂Cu₃O₇₋ₓ (HoBCO) was deposited. As a manufacturing condition, a laser deposition method was used with laser energy of 600 mJ. Oxygen was used as a film formation gas, a gas pressure was set to 26.7 kPa (200 Torr), and a distance between a deposition object (metal tape) and a target was kept 80 mm. An irradiation area on the target was set to 4 mm x 6 mm with a condenser lens to form a rectangular plume.

In the condition as described above, a Hastelloy tape as above was transferred through the plume to form a film with adjusting a frequency of a laser so as to obtain a desired thickness of 0.25 µm over a whole film. A sample as a reference was prepared by a method in which a superconductive film was deposited without transferring the Hastelloy tape, that is, at a transfer speed of 0, which Hastelloy tape was removed when the desired thickness of 0.25 µm was attained.

Samples having the oxide superconductive layer deposited thereon at respective three transfer speeds of 5 m/h, 10 m/h and 15 m/h were produced. Critical current values (1c) were measured together with the aforementioned sample with the transfer speed of 0. A Jc was calculated using the Ic obtained. Results are shown in Table 1. The results shown in Table 1 indicate a tendency of a value of Jc to increase as the transfer speed during deposition of the oxide superconductive layer increases.

**[Table 1]**

| Transfer Speed (m/h) | 0 | 5 | 10 | 15 |
|---|---|---|---|---|
| Critical Current Density (MA/cm²) | 1.01 | 1.06 | 1.45 | 2.19 |

### (Example 2)

The orientation substrate of the Ni group alloy used in example 1 which had the intermediate layer deposited thereon was used, and an HoBCO film was deposited thereon as in example 1. As a manufacturing condition, the distance between the deposition object (metal tape) and the target was changed to 60 mm, and the irradiation area on the target was set to 0.6 mm x 40 mm with a condenser lens to form a line plume. The other conditions were made similar to those in example 1.

In example 2, the oxide superconductive layer was formed at respective four transfer speeds of 1.7 m/h, 2.5 m/h, 5 m/h, and 6.6 m/h to obtain samples. Critical current values (Ic) of the samples were measured. A critical current density (Jc) was measured using the Ic obtained. Results are shown in Table 2. Table 2 indicates that, in example 2, there is also a tendency of the Jc to increase as the transfer speed increases, as in example 1. In particular, the value of Jc increased at the transfer speed of at least 5 m/h.

**[Table 2]**

| Transfer Speed (m/h) | 1.7 | 2.5 | 5 | 6.6 |
|---|---|---|---|---|
| Critical Current Density (MA/cm²) | 1.09 | 1.17 | 1.61 | 2.07 |

As described above, since the transfer speed is increased and a sufficiently large value of the critical current density is obtained with the method of manufacturing an oxide superconductive wire according to the present invention, this method is more effective in manufacturing the oxide superconductive wire having a long length as compared to a conventional method.

### Industrial Applicability

The present invention can be applied to an art of a method of manufacturing an oxide superconductive wire.

## Claims

1. A method of manufacturing an oxide superconductive wire, comprising: the step of positioning a metal tape (6) in a position at a distance (L) of at most 100 mm from a target (7) for generating an oxide; and
the step of forming an oxide superconductive layer (12) on said metal tape (6) using a vapor deposition method while transferring said metal tape (6) at a transfer speed of at most 5 m/h with keeping the distance (L) between said metal tape (6) and said target (7) of at most 100 mm.

2. The method of manufacturing an oxide superconductive wire according to claim 1, wherein
said vapor deposition method is a pulsed laser deposition (PLD) method.

3. The method of manufacturing an oxide superconductive wire according to claim 1, wherein
said oxide superconductive layer (12) is a rare-earth-barium-copper-based superconductive oxide (RE123; RE = rare-earth element, Y).
